# EUROPEAN PATENT APPLICATION

(11) **EP 4 258 823 A1**
(43) Date of publication of application: **11.10.2023**
(21) Application number: 21900616.0
(22) Date of filing: 01.12.2021
(51) Int. Cl.: H05K 1/02, G01N 29/02, H03H 9/25

(54) **ELEMENT MOUNTING SUBSTRATE AND SAW SENSOR DEVICE**

(30) Priority: 01.12.2020 JP 2020199645
(71) Applicant: Kyocera Corporation, Kyoto-shi Kyoto 612-8501 (JP)
(72) Inventor: KISHIMOTO, Kyosuke, Kyoto-shi, Kyoto 612-8501 (JP); KATTA, Hiroshi, Kyoto-shi, Kyoto 612-8501 (JP)
(74) Representative: TBK
(86) International application number: PCT/JP2021/044007
(87) International publication number: WO 2022/118864

(57) **Abstract**

Noise derived from electromagnetic coupling due to size reduction of an element mounting substrate is reduced. In an embodiment of the present disclosure, an element mounting substrate includes an insulation layer, an input wiring line and an output wiring line disposed on the insulation layer, and a ground layer disposed on the insulation layer, located around the input wiring line and the output wiring line, and including an exposed region where the insulation layer is exposed. The exposed region of the ground layer overlaps a region where the input wiring line and the output wiring line are close to each other. A SAW element is mounted on the element mounting substrate. With this configuration, the noise derived from the electromagnetic coupling generated between the input wiring line and the output wiring line can be reduced, and measurement accuracy can be improved.

## Description

### TECHNICAL FIELD

The present disclosure relates to an element mounting substrate and a SAW sensor device.

### BACKGROUND OF INVENTION

In recent years, there has been a demand for techniques for reducing the size of various sensors and sensor devices. For example, there is a technique for providing a surface acoustic wave (SAW) sensor that can be reduced in size and increased in frequency (for example, Patent Document 1).

### CITATION LIST

### PATENT LITERATURE

Patent Document 1: JP 2007-225546 A

### SUMMARY

In an embodiment of the present disclosure, an element mounting substrate includes an insulation layer, an input wiring line and an output wiring line disposed on the insulation layer, and a ground layer disposed on the insulation layer, located around the input wiring line and the output wiring line, and including an exposed region where the insulation layer is exposed. The exposed region of the ground layer overlaps a region where the input wiring line and the output wiring line are close to each other.

In an embodiment of the present disclosure, a measurement device includes the element mounting substrate and a SAW element. The SAW element is mounted on the element mounting substrate, and includes a first electrode connected to the input wiring line and configured to generate an elastic wave, a second electrode connected to the output wiring line and configured to receive the elastic wave, and an element substrate configured to propagate the elastic wave.

### BRIEF DESCRIPTION OF THE DRAWINGS

FIG. 1 is a schematic view of a sensor device according to a first embodiment.
FIG. 2 is a schematic view of a SAW element according to the first embodiment.
FIG. 3A is a top view of an element mounting substrate according to the first embodiment.
FIG. 3B is a bottom view of the element mounting substrate according to the first embodiment.
FIG. 3C is a cross-sectional view taken along line I-I' of the element mounting substrate according to the first embodiment.
FIG. 3D is a cross-sectional view taken along line II-II' of the element mounting substrate according to the first embodiment.
FIG. 3E is a cross-sectional view taken along line III-III' of the element mounting substrate according to the first embodiment.
FIG. 4A is a bottom view of the element mounting substrate according to a second embodiment.
FIG. 4B is a cross-sectional view taking along line I-I' of the element mounting substrate according to the second embodiment.
FIG. 5A is a top view of the element mounting substrate according to a third embodiment.
FIG. 5B is a bottom view of the element mounting substrate according to the third embodiment.
FIG. 5C is a cross-sectional view taken along line I-I' of the element mounting substrate according to the third embodiment.
FIG. 6A is a bottom view of the element mounting substrate according to a fourth embodiment.
FIG. 6B is a cross-sectional view taken along line I-I' of the element mounting substrate according to the fourth embodiment.
FIG. 7 is a bottom view of the element mounting substrate of a variation according to the fourth embodiment.
FIG. 8 is a bottom view of the element mounting substrate of a variation according to the fourth embodiment.
FIG. 9A is a bottom view of the element mounting substrate according to a fifth embodiment.
FIG. 9B is a cross-sectional view taken along line I-I' of the element mounting substrate according to the fifth embodiment.

### DESCRIPTION OF EMBODIMENTS

### First Embodiment

A SAW sensor device 1 according to a first embodiment of the present disclosure will be described below with reference to drawings.

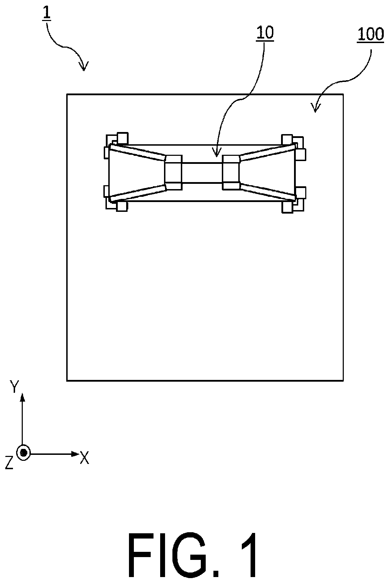

FIG. 1 schematically illustrates the SAW sensor device 1 according to the first embodiment.

The SAW sensor device 1 can detect, as a target, a specific substance in a measurement target (sample). The SAW sensor device 1 includes a SAW element 10 (external element) that can detect a specific substance and an element mounting substrate 100 on which the SAW element 10 is mounted. The SAW element 10 is electrically connected to the element mounting substrate 100.

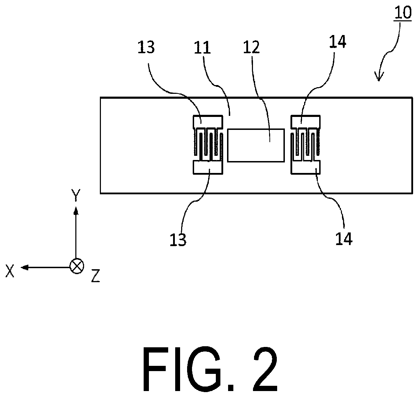

FIG. 2 schematically illustrates the SAW element 10 according to the first embodiment.

The SAW element 10 includes an element substrate (hereinafter referred to as a "piezoelectric substrate" in the present description) 11, a reaction unit 12, a first electrode (hereinafter referred to as "an input IDT (Interdigital Transducer) electrode" in the present description) 13, and a second electrode (hereinafter referred to as "an output IDT electrode" in the present description) 14. The reaction unit 12 is disposed on the piezoelectric substrate 11 and reacts with the specific substance in the sample. The input IDT electrode 13 propagates a surface acoustic wave (elastic wave) obtained by receiving and converting an electrical signal toward the reaction unit 12. The output IDT electrode 14 receives the surface acoustic wave passing through the reaction unit 12 and converts the surface acoustic wave into an electrical signal. The reaction unit 12 is located so as to be sandwiched between the input IDT electrode 13 and the output IDT electrode 14.

The piezoelectric substrate 11 can propagate the surface acoustic wave generated from the input IDT electrode 13. The piezoelectric substrate 11 may be made of a substrate of a single crystal having piezoelectric properties, such as quartz, lithium tantalate (LiTaO3) single crystal, or lithium niobate (LiNbO3) single crystal.

As described above, the reaction unit 12 is disposed on the piezoelectric substrate 11 and can react with the specific substance in the sample. The reaction unit 12 includes a metal film formed on an upper surface of the piezoelectric substrate 11 and a reactant that is fixed on an upper surface of the metal film to react with the specific substance. The metal film may have a single-layer structure made of a gold layer, or a multi-layer structure such as a two-layer structure of a titanium layer and a gold layer located on the titanium layer, or a two-layer structure of a chromium layer and a gold layer located on the chromium layer. Instead of the metal film, for example, an oxide film such as SiO2 or TiO2 may be used. The reactant may be appropriately selected depending on an object to be detected of a detection target, and for example, when a specific cell, biological tissue, or the like in a sample liquid is the object to be detected, an aptamer composed of a nucleic acid or a peptide or an antibody can be used.

The input IDT electrode 13 can transmit a predetermined surface acoustic wave. The output IDT electrode 14 can receive the surface acoustic wave from the input IDT electrode 13. The input IDT electrode 13 and the output IDT electrode 14 are disposed on the piezoelectric substrate 11. The input IDT electrode 13 includes two electrode fingers. The output IDT electrode 14 includes two electrode fingers. As described above, the input IDT electrode 13, the output IDT electrode 14, and the reaction unit 12 are located on the same straight line. The input IDT electrode 13 and the output IDT electrode 14 may have a single-layer structure made of, for example, a gold thin film layer, or may have a multi-layer structure such as a three-layer structure of a titanium layer, a gold layer, and a titanium layer from the piezoelectric substrate 11 side, or a three-layer structure of a chromium layer, a gold layer, and a chromium layer from the piezoelectric substrate 11 side.

The SAW element 10 and each component of the SAW element 10 can be manufactured by a known manufacturing method.

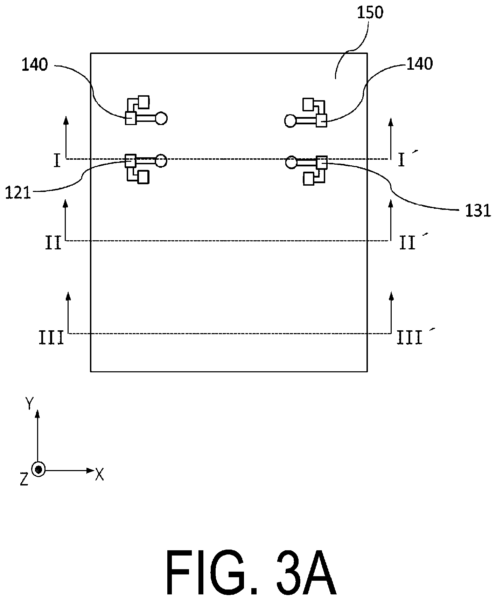

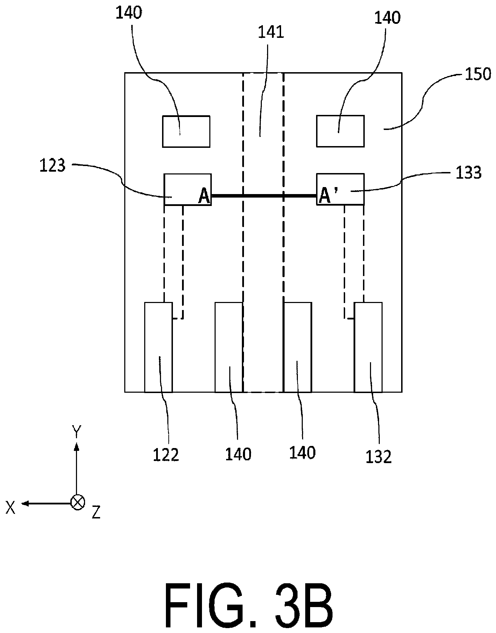

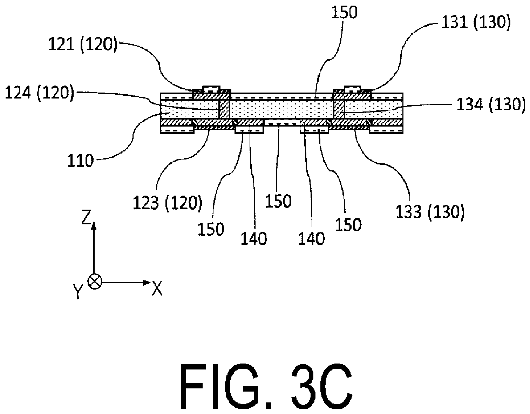

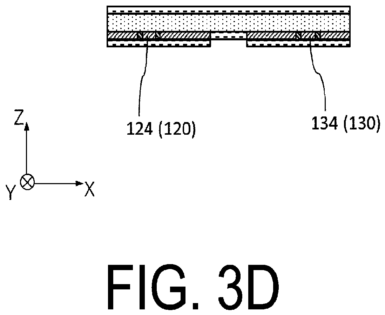

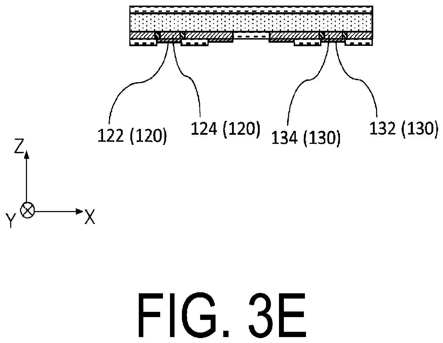

FIGs. 3A to 3E schematically illustrate the element mounting substrate 100. In FIGs. 3A and 3B, a surface of the element mounting substrate 100 is covered with an insulator 150. However, a first wiring line 124, a second wiring line 134, and an exposed region 141 are illustrated by broken lines for the sake of explanation.

The element mounting substrate 100 can support the SAW element 10 and can supply an electrical signal to the SAW element 10. The element mounting substrate 100 includes a first insulation layer 110, an input wiring line 120, an output wiring line 130, and a ground layer 140. The input wiring line 120 and the output wiring line 130 are disposed on the first insulation layer 110 and are connected to the SAW element 10. The ground layer 140 is located in the same layer in which the input wiring line 120 and the output wiring line 130 are located, and is located around the input wiring line 120 and the output wiring line 130.

The first insulation layer 110 can function as a substrate and can support the SAW element 10, the input wiring line 120, the output wiring line 130, and the ground layer 140. The first insulation layer 110 may be made of a dielectric body such as a resin material, a ceramic material, or a glass material, or a composite material thereof. The resin material may be, for example, epoxy resin or polyimide resin. The ceramic material may be, for example, silica, alumina, or zirconia.

The input wiring line 120 can transmit an electrical signal from the outside to the input IDT electrode 13 of the SAW element 10. The output wiring line 130 can transmit an electrical signal converted by the output IDT electrode 14 of the SAW element 10 to the outside. The input wiring line 120 is disposed on the first insulation layer 110 and is electrically connected to the input IDT electrode 13 of the SAW element 10. The output wiring line 130 is disposed on the first insulation layer 110 and is electrically connected to the output IDT electrode 14 of the SAW element 10.

The input wiring line 120 includes a first terminal 121 connected to one of the two electrode fingers included in the input IDT electrode 13. The output wiring line 130 includes a second terminal 131 connected to one of the two electrode fingers included in the output IDT electrode 14. The first terminal 121 and the second terminal 131 may be made of a metal material such as a single-layer structure made of a thin film of gold, lead, or the like, a two-layer structure made of nickel and gold, titanium and gold, or the like, or a three-layer structure made of nickel, palladium, and gold, or the like. The first terminal 121 and the second terminal 131 can be formed by a known manufacturing method, and are formed by, for example, electroless plating in the present embodiment.

The input wiring line 120 includes an external connection terminal 122 connected to an external device. The output wiring line 130 includes an external connection terminal 132 connected to the external device. The external connection terminals 122 and 132 are connected to, for example, an external electrical signal source, and supply an electrical signal to the SAW sensor device 1. The external connection terminals 122 and 132 may be made of a metal material such as a single-layer structure made of a thin film of gold, lead, or the like, a two-layer structure made of nickel and gold, titanium and gold, or the like, or a three-layer structure made of nickel, palladium, and gold, or the like. The external connection terminals 122 and 132 can be formed by a known manufacturing method, and are formed by, for example, electroless plating in the present embodiment.

The input wiring line 120 includes the first wiring line 124 connected to the first terminal 121 and the external connection terminal 122. The output wiring line 130 includes the second wiring line 134 connected to the second terminal 131 and the external connection terminal 132. With the above-described configuration, the element mounting substrate 100 can be connected to the SAW element 10, the external device, or the like by a connection method such as wire bonding, and can suppress deterioration of a connecting portion by plating.

The first wiring line 124 and the second wiring line 134 may be made of a metal material such as copper or aluminum. The first wiring line 124 and the second wiring line 134 can be formed by a known manufacturing method. In the present embodiment, the first wiring line 124 and the second wiring line 134 are formed simultaneously with the ground layer 140 by, for example, providing a gap or the like at outer edges of the first wiring line 124 and the second wiring line 134 based on a copper foil disposed on the first insulation layer 110 and applying insulation.

The input wiring line 120 includes a third terminal 123. The output wiring line 130 includes a fourth terminal 133. The third terminal 123 is connected to the first wiring line 124. The fourth terminal 133 is connected to the second wiring line 134. The third terminal 123 and the fourth terminal 133 can be used as probe terminals, and can be used for, for example, a performance test after the SAW element 10 is mounted. The third terminal 123 and the fourth terminal 133 may be omitted as appropriate. In this case, the external connection terminals 122 and 132 may be used as the probe terminals. Instead of the external connection terminals 122 and 132, the third terminal 123 and the fourth terminal 133 may be used for connection to the external electrical signal source or the like. In this case, the external connection terminals 122 and 132 may be omitted as appropriate.

The third terminal 123 and the fourth terminal 133 may be made of a metal material such as a single-layer structure made of a thin film of gold, lead, or the like, a two-layer structure made of nickel and gold, titanium and gold, or the like, or a three-layer structure made of nickel, palladium, and gold, or the like. The third terminal 123 and the fourth terminal 133 can be formed by a known manufacturing method, and are formed by, for example, electroless plating in the present embodiment.

The ground layer 140 is electrically connected to an electrode finger of the two electrode fingers of the input IDT electrode 13 that is different from the electrode finger connected to the input wiring line 120, and can serve as a potential reference. The ground layer 140 is electrically connected to an electrode finger of the two electrode fingers of the output IDT electrode 14 that is different from the electrode finger connected to the output wiring line 130, and can serve as a potential reference.

The ground layer 140 includes terminals each electrically connected to a respective one of the input IDT electrode 13 and the output IDT electrode 14 of the SAW element 10. The ground layer 140 includes a terminal connected to the external device. The ground layer 140 includes a terminal connected to the external device, and thus can be grounded via, for example, the external device .

The ground layer 140 may be made of a metal material such as copper or aluminum. The ground layer 140 can be provided by a known manufacturing method. In the present embodiment, the ground layer 140 is formed simultaneously with the first wiring line 124 and the second wiring line 134 by, for example, providing a gap or the like with outer edges of the first wiring line 124 and the second wiring line 134 based on a copper foil disposed on the first insulation layer 110 and applying insulation.

As described above, the ground layer 140 is located around the input wiring line 120 and the output wiring line 130. The ground layer 140 includes the exposed region 141 where the first insulation layer 110 is exposed. The exposed region 141 is located between the input wiring line 120 and the output wiring line 130, and overlaps a region where the input wiring line 120 and the output wiring line 130 are close to each other.

Conventionally, the ground layer has been provided over a wide area in order to reduce impedance. Thus, for example, in a case where the wiring line and the ground layer are disposed on a single-layer substrate, the ground layer may be disposed on the entire region other than the wiring line. However, when such a substrate is reduced in size, the distance between the wiring lines is short, and current leaks from the input wiring line to the output wiring line via the ground layer resulting in noise, and thus the measurement accuracy of the sensor device may be reduced.

On the other hand, in the present embodiment, as described above, the ground layer 140 includes the exposed region 141, and the exposed region 141 overlaps the region where the input wiring line 120 and the output wiring line 130 are close to each other. In other words, the first insulation layer 110 exposed from the exposed region 141 is located between the input wiring line 120 and the output wiring line 130. Thus, as compared with a case where the ground layer 140 is located between the input wiring line 120 and the output wiring line 130, current leakage from the input wiring line 120 to the output wiring line 130 can be reduced, and thus the measurement accuracy of the SAW sensor device 1 can be improved.

In the present embodiment, the exposed region 141 extends from one side of the element mounting substrate 100 to the opposite side thereof, and the ground layer 140 is divided into two by the exposed region 141 between the input wiring line 120 and the output wiring line 130. As a result, the current leaking from the input wiring line 120 can be suppressed from bypassing the exposed region 141 and being transmitted to the output wiring line 130, so that further improvement in the measurement accuracy of the SAW sensor device 1 can be expected.

The input wiring line 120 and the output wiring line 130 of the present embodiment are closest to each other between the third terminal 123 and the fourth terminal 133 (between A-A' in FIG. 3B), and the exposed region 141 is located so as to separate the third terminal 123 and the fourth terminal 133 from each other. The closest part between the input wiring line 120 and the output wiring line 130 can be changed as appropriate, and may be, for example, between the first wiring line 124 and the second wiring line 134. The closest part between the input wiring line 120 and the output wiring line 130 may be between any terminal in the input wiring line 120 and the second wiring line 134 in the output wiring line 130, or between the first wiring line 124 in the input wiring line 120 and any terminal in the output wiring line 130. The positions of the input wiring line 120 and the output wiring line 130 may be exchanged or changed as appropriate. When the term "region close to each other" is simply referred to, the region includes the closest region.

The element mounting substrate 100 of the present disclosure may further include the insulator 150 that covers at least a part of the first insulation layer 110, the ground layer 140, the input wiring line 120, and the output wiring line 130. The insulator 150 serves to reduce deterioration of the covered components. The insulator 150 is made of an insulator material such as epoxy resin or acrylic resin.

As described above, the first terminal 121 and the second terminal 131 are connected to the input IDT electrode 13 and the output IDT electrode 14. The first terminal 121 and the second terminal 131 are disposed on a different surface of the first insulation layer 110 from a surface on which the ground layer 140 is disposed. According to this configuration, the sample can be suppressed from coming into contact with the exposed region 141 of the ground layer 140 when the SAW sensor device 1 is used, and thus characteristics (for example, dielectric constant and insulating property) of the first insulation layer 110 can be suppressed from changing.

The first terminal 121 and the second terminal 131 may be disposed on the same surface of the first insulation layer 110 as the surface on which the ground layer 140 is disposed. In the present embodiment, the first terminal 121 and the second terminal 131 are connected to the input IDT electrode 13 and the output IDT electrode 14 by wire bonding.

The third terminal 123 and the fourth terminal 133 are disposed on a different surface of the first insulation layer 110 from the surface on which the first terminal 121 and the second terminal 131 are disposed. At this time, since the first terminal 121 and the second terminal 131 are used for connection to the SAW element 10, the third terminal 123 and the fourth terminal 133 are located on a different surface from the surface on which the SAW element 10 is mounted. Thus, in the case where the third terminal 123 and the fourth terminal 133 are disposed on a surface different from the surface on which the first terminal 121 and the second terminal 131 are disposed, noise can be suppressed from being generated by the sample coming into contact with a transmission line when the SAW sensor device 1 is used.

The third terminal 123 and the fourth terminal 133 may be disposed on the same surface of the first insulation layer 110 as the surface on which the first terminal 121 and the second terminal 131 are disposed. In the case where the third terminal 123 and the fourth terminal 133 are disposed on the same surface as the surface on which the first terminal 121 and second terminal 131 are disposed, the first terminal 121, the second terminal 131, the third terminal 123, and the fourth terminal 133 can be disposed in the same process.

As described above, the exposed region 141 is located between the input wiring line 120 and the output wiring line 130. In the present embodiment, the exposed region 141 is covered with the insulator 150, but the insulator 150 may be omitted as appropriate. In the case where the exposed region 141 is covered with the insulator 150, the first insulation layer 110 in the exposed region 141 can be protected. It is effective to prevent a change in dielectric constant due to dew condensation on a surface of the exposed region 141. For example, the exposed region 141 may be formed when the first wiring line 124, the second wiring line 134, and the ground layer 140 are provided on the substrate, or may be formed by etching or the like after the insulator 150 is provided.

The present disclosure is not limited to the above-described embodiment, and various modifications, enhancements, and the like may be made without departing from the scope of the present disclosure. Various embodiments will be described below in the form of the element mounting substrate.

For example, although the present embodiment has been described as the SAW sensor device in which the SAW element is mounted on the element mounting substrate, the sensor element mounted on the mounting substrate is not limited to the SAW element. For example, as long as an element is used in a sensor device in which the electrical signal is input from the external electrical signal source via the element mounting substrate and the electrical signal is output from the element via the element mounting substrate, the element mounting substrate according to the present disclosure can be used, and reduction in current leakage due to size reduction can be expected.

For example, in the present embodiment, the first terminal 121 and the second terminal 131 are located on the same surface of the substrate, and the third terminal 123 and the fourth terminal 133 are located on the same surface of the substrate. Each of the first terminal 121 and the third terminal 123 is located on a respective one of different surfaces of the substrate, and each of the second terminal 131 and the fourth terminal 133 is located on a respective one of different surfaces of the substrate. However, these positional relationships may be changed as appropriate.

Each of the first wiring line 124 and the second wiring line 134 connects the terminals in a respective one of the input wiring line 120 and the output wiring line 130, and inputs and output the electrical signal to and from the SAW element 10 through the terminals. The first wiring line 124, the second wiring line 134, and the ground layer 140 are disposed on the same plane of the first insulation layer 110 to form a so-called coplanar structure, but the structure of the first wiring line 124 and the second wiring line 134 may be changed as appropriate. The structure of the first wiring line 124 and the second wiring line 134 may be, for example, a coplanar strip structure.

### Second Embodiment

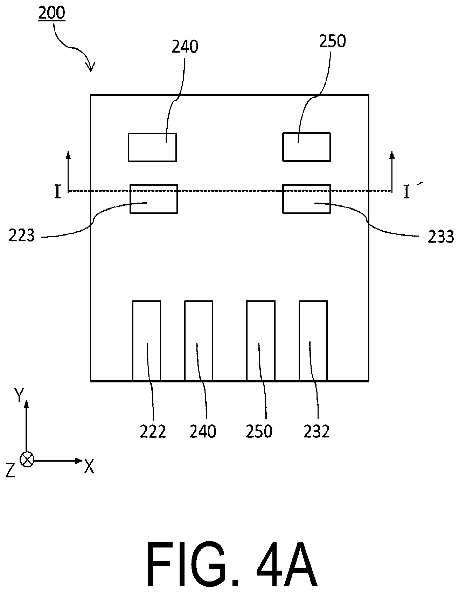

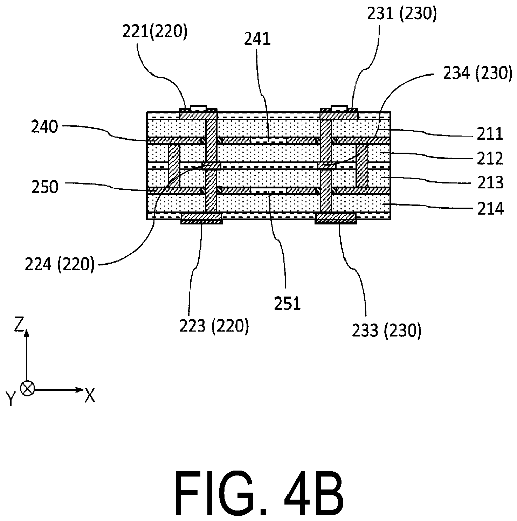

FIGs. 4A and 4B schematically illustrate an element mounting substrate 200 according to a second embodiment.

The element mounting substrate 200 of the second embodiment is different from the above-described embodiment in that the element mounting substrate 200 is a multilayer substrate. The element mounting substrate 200 includes a first insulation layer 211, a first ground layer 240, a second insulation layer 212, an input wiring line 220, an output wiring line 230, a third insulation layer 213, a second ground layer 250, and a fourth insulation layer 214. The first ground layer 240 is located on the first insulation layer 211. The second insulation layer 212 is layered on the first ground layer 240. The input wiring line 220 and the output wiring line 230 are disposed on the second insulation layer 212. The third insulation layer 213 is layered on the input wiring line 220 and the output wiring line 230. The second ground layer 250 is located on the third insulation layer 213. The fourth insulation layer 214 is layered on the second ground layer 250.

In the present embodiment, the first insulation layer 211, the second insulation layer 212, the third insulation layer 213, and the fourth insulation layer 214 can function as the substrate. The first insulation layer 211, the second insulation layer 212, the third insulation layer 213, and the fourth insulation layer 214 may be made of the same material or different materials.

In the present embodiment, the input wiring line 220 and the output wiring line 230 are located in a layer different from the first ground layer 240 and the second ground layer 250. Each of the input wiring line 220 and the output wiring line 230 is also disposed on the first insulation layer 211 and the fourth insulation layer 214 through via holes penetrating each insulation layer. Each of the first ground layer 240 and the second ground layer 250 is also disposed on the first insulation layer 211 and the fourth insulation layer 214 through via holes penetrating each insulation layer.

In the present embodiment, each of the first ground layer 240 and the second ground layer 250 is separated into two parts between the input wiring line 220 and the output wiring line 230, and includes a respective one of the exposed regions 241 and 251 where the insulation layer is exposed. In the present embodiment, the exposed regions 241 and 251 are covered with insulators present between the layers. The insulators between the layers may be omitted as appropriate.

The input wiring line 220 and the output wiring line 230 of the present embodiment are closest to each other between the third terminal 223 and the fourth terminal 233. On the other hand, the first ground layer 240 is disposed on the first insulation layer 211, and thus current leakage may occur between a first wiring line 224 and a second wiring line 234. Thus, in the present embodiment, the exposed region 241 is located so as to separate the first wiring line 224 and the second wiring line 234 from each other on the first insulation layer 211. The second ground layer 250 is disposed on the third insulation layer 213, and thus current leakage may occur between the first wiring line 224 and the second wiring line 234. Thus, in the present embodiment, the exposed region 251 is located so as to separate the first wiring line 224 and the second wiring line 234 from each other on the third insulation layer 213. Also in this case, the exposed regions 241 and 251 overlap a region where the input wiring line 220 and the output wiring line 230 are closest to each other when viewed from above or below.

The first terminal 221 and the second terminal 231 are connected to a respective one of the first wiring line 224 and the second wiring line 234, on the first insulation layer 211. The third terminal 223 and an external connection terminal 222 are connected to the first wiring line 224 on the fourth insulation layer 214, and the fourth terminal 233 and an external connection terminal 232 are connected to the second wiring line 234 on the fourth insulation layer 214. These positional relationships can be changed as appropriate.

In the present embodiment, each of the first wiring line 224 and the second wiring line 234 is also disposed on the first insulation layer 211 and the fourth insulation layer 214 through vias penetrating each insulation layer. In the present embodiment, the first wiring line 224, the second wiring line 234, the first ground layer 240, and the second ground layer 250 form a strip line structure. The structure of the first wiring line 224 and the second wiring line 234 can be changed as appropriate. The first ground layer 240 may be located on the same surface on the first insulation layer 211 as the first terminal 221, and the second ground layer 250 may be located on the same surface on the fourth insulation layer 214 as the second terminal 231. In this case, electromagnetic noise from the outside can be prevented more than in a case where each ground layer is located inside the element mounting substrate 200.

### Third Embodiment

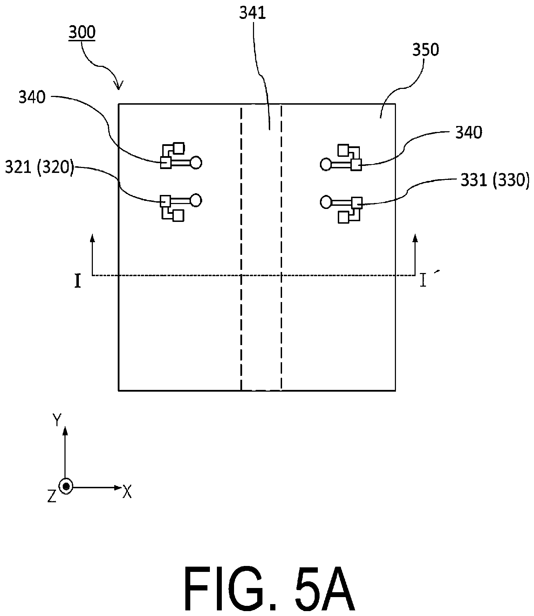

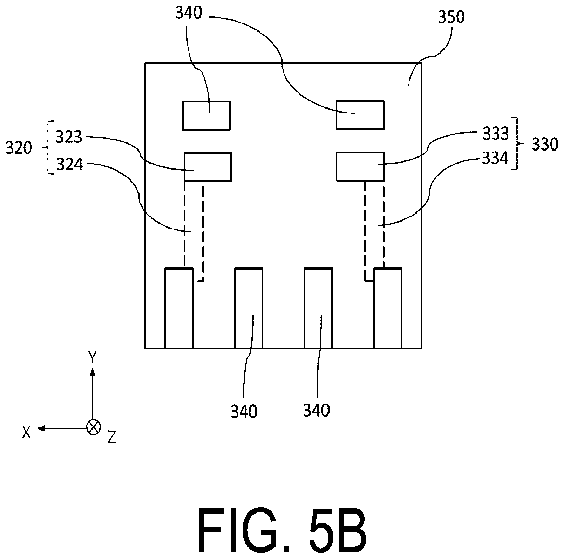

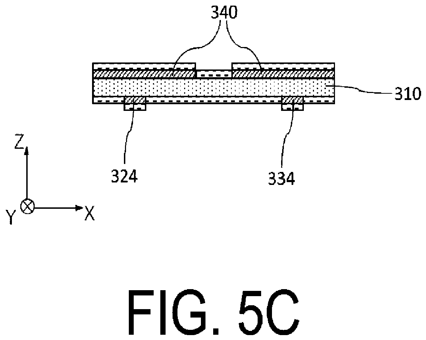

FIGs. 5A to 5C schematically illustrate an element mounting substrate 300 according to a third embodiment. In FIGs.5A and 5B, a surface of the element mounting substrate 300 is covered with an insulator 350. However, a first wiring line 324, a second wiring line 334, and an exposed region 341 are illustrated by broken lines for the sake of explanation.

The element mounting substrate 300 of the third embodiment is not markedly different from that of the first embodiment in terms of components included therein, but is different in that a ground layer 340 is disposed on the same surface of the first insulation layer 310 as the surface on which the first terminal 321 and the second terminal 331 are located.

The input wiring line 320 and the output wiring line 330 of the present embodiment are closest to each other between the third terminal 323 and the fourth terminal 333. On the other hand, the ground layer 340 is disposed on the same surface of the first insulation layer 310 as the surface on which the first terminal 321 and the second terminal 331 are located, and thus current leakage may occur between the first terminal 321 and the second terminal 331. Thus, in the present embodiment, the exposed region 341 is located so as to separate the first terminal 321 and the second terminal 331 from each other.

In the present embodiment, the first wiring line 324, the second wiring line 334, and the ground layer 340 form a micro strip line structure. The structure of the first wiring line 324 and the second wiring line 334 can be changed as appropriate.

### Fourth Embodiment

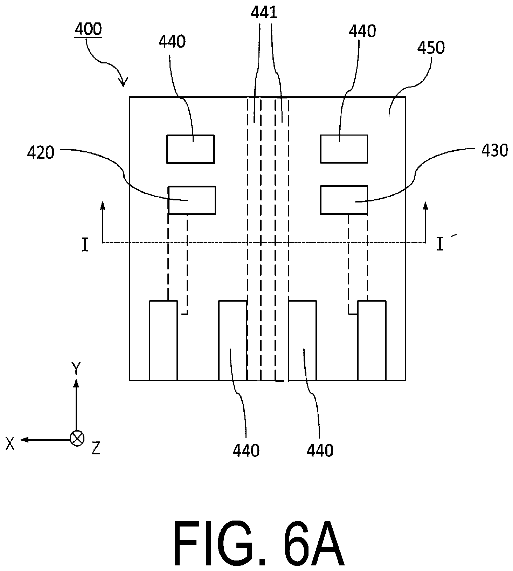

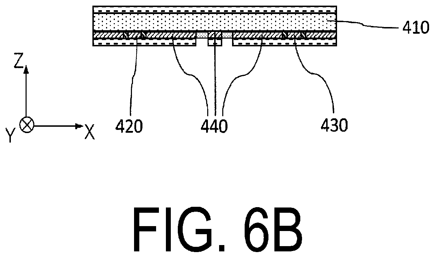

FIGs. 6A and 6B schematically illustrate an element mounting substrate 400 according to a fourth embodiment. In FIG. 6A, a surface of the element mounting substrate 400 is covered with an insulator 450. However, a part of an input wiring line 420, a part of an output wiring line 430, and an exposed region 441 are illustrated by broken lines for the sake of explanation.

The element mounting substrate 400 of the fourth embodiment is not markedly different from that of the first embodiment in terms of components included therein, but is different in that a ground layer 440 is separated and two exposed regions 441 in which the first insulation layer 410 is exposed are included. In the present embodiment, three or more exposed regions 441 may be present. In a case where the element mounting substrate 400 has a complicated signal pattern in which there are a plurality of regions where the input wiring line 420 and the output wiring line 430 are close to each other, the current leakage in each of the close regions can be reduced by including the exposed region 441 in each of the close regions. As in the present embodiment, the ground layer 440 sandwiched between the exposed regions 441 is included, and thus a new wiring line can be disposed between the input wiring line 420 and the output wiring line 430 while the influence of current leakage is suppressed.

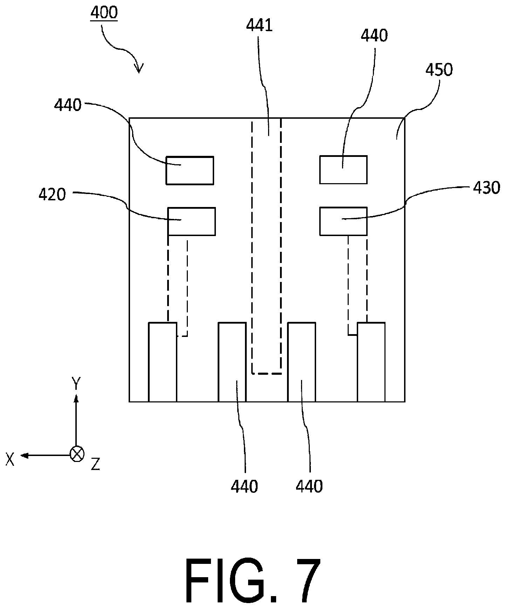

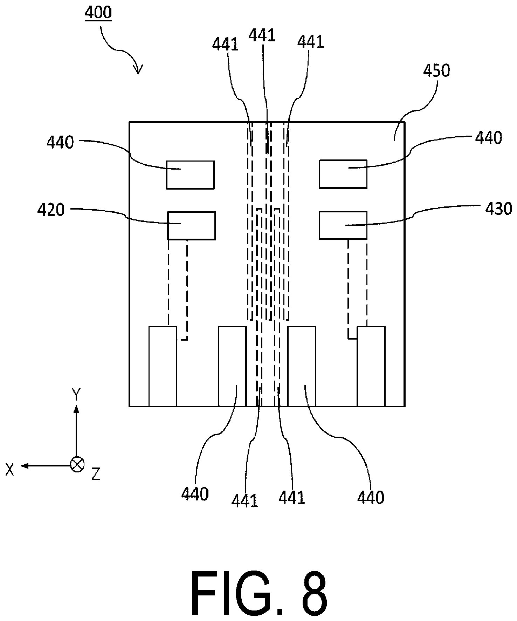

The ground layer 440 need not be completely separated, and may have a shape in which, for example, the ground layer 440 is connected at only an upper end or only a lower end (for example, a shape in which the ground layer 440 is connected at only the lower end in FIG. 7). According to this configuration, the distance over which current leaking from the input wiring line 420 is transmitted through the ground layer 440 can be increased, and reduction in current leakage can be expected. In this case, the shape of the ground layer 440 separated by the exposed region 441 can also be a meandering shape by being alternately connected at the upper end and the lower end (for example, the form in FIG. 8). According to this configuration, the distance over which the current leaking from the input wiring line 420 is transmitted through the ground layer 440 can be further increased without increasing the width of the exposed region, and further reduction in current leakage can be expected. Since current leakage is distributed over a certain width, a certain effect can be expected even in a shape in which only the terminals of the ground layer 440 connected to the external device are separated from each other.

### Fifth Embodiment

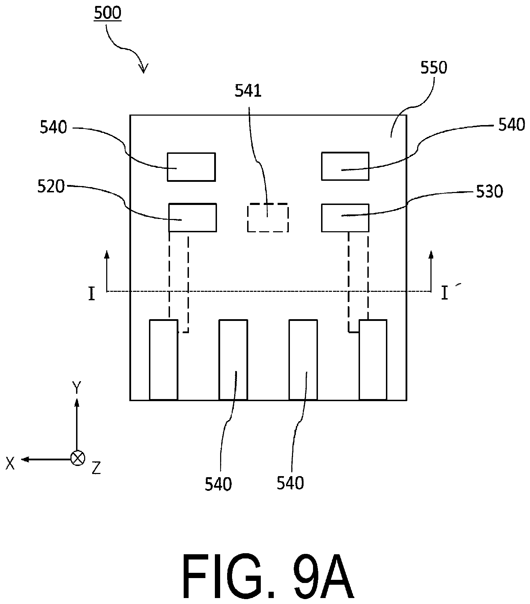

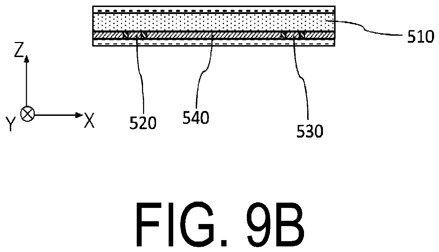

FIGs. 9A and 9B schematically illustrate an element mounting substrate 500 according to a fifth embodiment. In FIG. 9A, a surface of the element mounting substrate 500 is covered with an insulator 550. However, a part of an input wiring line 520, a part of an output wiring line 530, and an exposed region 541 are illustrated by broken lines for the sake of explanation.

The element mounting substrate 500 of the fifth embodiment is not markedly different from that of the first embodiment in terms of components included therein, but is different in that a ground layer 540 is separated and the exposed region 541 where the first insulation layer 510 is exposed is present only in the closest part between the input wiring line 520 and the output wiring line 530.

Current leakage is most likely to occur at the closest part between the input wiring line 520 and the output wiring line 530. Thus, in the case where at least the closest part between the input wiring line 520 and the output wiring line 530 are separated from each other, the effect of reducing current leakage can be expected. As compared with the other embodiments, an area on the element mounting substrate 500 occupied by the exposed region 541 is smaller, and thus an area of the ground layer 540 can be kept large while current leakage is reduced.

In the foregoing description, several embodiments have been described in order to clearly disclose the present disclosure. However, the appended claims are not to be limited to the embodiments described above and should be configured to embody all variations and alternative configurations that those skilled in the art may make within the underlying matter set forth herein. The requirements described in some embodiments can be freely combined. For example, the SAW sensor device and the element mounting substrate may be configured by appropriately combining components and steps of the above-described embodiments.

The SAW sensor device or the element mounting substrate according to the embodiments in the present description can be manufactured by a known manufacturing method, but is not particularly limited thereto.

### REFERENCE SIGNS

1 SAW sensor device
10 SAW element
11 Piezoelectric substrate
12 Reaction unit
13 Input IDT electrode
14 Output IDT electrode
100, 200, 300, 400, 500 Element mounting substrate
110, 310, 410, 510 First insulation layer
120, 220, 320, 420, 520 Input wiring line
121, 221, 321 First terminal
122, 222 External connection terminal
123, 223, 323 Third terminal
124, 224 First wiring line
130, 230, 330, 430, 530 Output wiring line
131, 231, 331 Second terminal
132, 232 External connection terminal
133, 233, 333 Fourth terminal
134, 234 Second wiring line
140, 340, 440, 540 Ground layer
141, 341, 441, 541 Exposed region
150, 350, 450, 550 Insulator
211 First insulation layer
212 Second insulation layer
213 Third insulation layer
214 Fourth insulation layer
240 First ground layer
241 Exposed region
250 Second ground layer
251 Exposed region

## Claims

1. An element mounting substrate comprising:
an insulation layer;
an input wiring line and an output wiring line disposed on the insulation layer; and
a ground layer disposed on the insulation layer, located around the input wiring line and the output wiring line, and comprising an exposed region where the insulation layer is exposed wherein
the exposed region of the ground layer overlaps a region where the input wiring line and the output wiring line are close to each other.

2. The element mounting substrate according to claim 1, further comprising:
a first terminal disposed on the input wiring line and connected to an external element, and
a first wiring line connected to the first terminal, wherein
the output wiring line comprises a second terminal connected to the external element and a second wiring line connected to the second terminal.

3. The element mounting substrate according to claim 2, wherein
the first terminal and the second terminal are disposed on a same insulation layer as the ground layer.

4. The element mounting substrate according to claim 3, wherein
the first terminal and the second terminal are disposed on a different surface of the insulation layer from the ground layer.

5. The element mounting substrate according to any one of claims 2 to 4, wherein
the input wiring line comprises a third terminal different from the first terminal, and
the output wiring line comprises a fourth terminal different from the second terminal.

6. The element mounting substrate according to claim 5, wherein
the third terminal and the fourth terminal are disposed on a different surface of the insulation layer from the first terminal and the second terminal.

7. The element mounting substrate according to claim 5, wherein
the third terminal and the fourth terminal are disposed on a same surface of the insulation layer as the first terminal and the second terminal.

8. The element mounting substrate according to any one of claims 1 to 7, wherein the ground layer is covered with an insulator.

9. The element mounting substrate according to any one of claims 1 to 8, wherein the exposed region is covered with an insulator.

10. The element mounting substrate according to any one of claims 1 to 9, wherein the exposed region extends to any one side of the insulation layer.

11. The element mounting substrate according to any one of claims 1 to 10, wherein
the exposed region extends from any one side of the insulation layer to another side.

12. The element mounting substrate according to any one of claims 1 to 11, wherein
the exposed region extends from any one side of the insulation layer to the opposite side thereof.

13. The element mounting substrate according to any one of claims 1 to 12, further comprising:
a plurality of the exposed regions.

14. A SAW sensor device comprising:
a SAW element mounted on the element mounting substrate according to any one of claims 1 to 13, the SAW element comprising
a first electrode connected to the input wiring line and configured to generate an elastic wave,
a second electrode connected to the output wiring line and configured to receive the elastic wave, and
an element substrate configured to propagate the elastic wave.
